# EUROPÄISCHE PATENTANMELDUNG

(11) **EP 4 723 820 A1**
(43) Veröffentlichungstag der Anmeldung: **08.04.2026**
(21) Anmeldenummer: 25206180.9
(22) Anmeldetag: 01.10.2025
(51) Int. Cl.: H05K 7/20, H10W 40/60

(54) **LEITERPLATTENANORDNUNG**

(30) Priorität: 07.10.2024 DE 102024128812
(71) Anmelder: Rolls-Royce Deutschland Ltd & Co KG, 15827 Blankenfelde-Mahlow (DE)
(72) Erfinder: WALTRICH, Uwe, 15827 Blankenfelde-Mahlow (DE); SCHAMBERGER, Niklas, 15827 Blankenfelde-Mahlow (DE); BOHLLÄNDER, Marco, 15827 Blankenfelde-Mahlow (DE); BØE, Maria, 15827 Blankenfelde-Mahlow (DE)

(57) **Zusammenfassung**

Die Erfindung betrifft eine Leiterplattenanordnung, die aufweist: eine Leiterplatte (1) mit einer Oberseite (11) und einer Unterseite (12), elektrische Module (4) mit einer Oberseite (41) und einer Unterseite (42) und einen Kühlkörper (3), der thermisch mit der Unterseite (42) der elektrischen Module (4) gekoppelt ist. Es ist weiter vorgesehen, dass der Kühlkörper (3) eine strukturierte Oberseite (30) aufweist, die eine Mehrzahl von Kavitäten (31) und zwischen den Kavitäten (31) angeordnete Auflagestrukturen (32) umfasst, die eine Auflagefläche (33) für die Leiterplatte (1) bilden, wobei die Unterseite (12) der Leiterplatte (1) auf der Auflagefläche (33) aufliegt und der aufliegende Bereich der Unterseite (12) eine untere Anlagefläche (13) bildet, die elektrischen Module (4) in die Kavitäten (31) des Kühlkörpers (3) hineinragen, und an der Oberseite (11) der Leiterplatte (1) an Anpresspunkten (14), die der unteren Anlagefläche (13) gegenüber liegen, vorstehende Strukturen (25) eines Niederhalters (2) oder eines Deckels (6) anliegen, die die Anpresspunkte (14) mit einer Niederhaltekraft beaufschlagen.

## Beschreibung

Die Erfindung betrifft eine Leiterplattenanordnung gemäß dem Oberbegriff des Patentanspruchs 1.

Es ist bekannt, leiterplattenbasierte Leistungselektronikbaugruppen für eine effektive Kühlung mittels Schraubverbindungen an einen Kühlkörper anzudrücken. Die zu kühlenden Leistungselektronikbaugruppen - auch als Prepackage-Module bezeichnet - befinden sich dabei auf der Unterseite einer Leiterplatte. Dabei ist anzustreben, die Anzahl der Schrauben so gering wie möglich zu halten, um das Leiterplattenlayout nicht zu stark durch die Schraubverbindungen einzuschränken. So führt jede Schraubverbindung zu Löchern in der Leiterplatte, die den verfügbaren Kupferquerschnitt reduzieren. Zudem müssen Luft- und Kriechstrecken auf der Oberseite als auch in den Innenlagen der Leiterplatte eingehalten werden, die den verfügbaren Kupferquerschnitt weiter reduzieren.

Gleichzeitig existieren thermische und mechanische Anforderungen, beispielsweise im Hinblick auf auftretende Vibrationen, die eine Mindestanzahl an Befestigungspunkten der Leiterplatte an den Kühlkörper erfordern. Gerade bei Hochstrom- und Hochspannungsanwendungen führt dies zur Verringerung der maximal möglichen Leistungsdichte der Leiterplatte.

Ein weiteres Problem, das bei Schraubprozessen auftritt, liegt in der Entstehung von elektrisch leitfähigem Abrieb während des Schraubprozesses, welcher als FOD Partikel zu Kurzschlüssen führen kann.

Der Erfindung liegt die Aufgabe zugrunde, eine Leiterplattenanordnung bereitzustellen, die mit einer geringen Anzahl von Schraubverbindungen oder sogar ohne Schraubverbindungen auskommt und trotzdem einen effektiven thermischen Kontakt zwischen leiterplattenbasierten Leistungselektronikbaugruppen und einem Kühlkörper erreicht.

Diese Aufgabe wird durch eine Leiterplattenanordnung mit den Merkmalen des Anspruchs 1 gelöst. Ausgestaltungen der Erfindung sind in den abhängigen Ansprüchen angegeben.

Danach betrachtet die Erfindung eine Leiterplattenanordnung, die eine Leiterplatte mit einer Oberseite und einer Unterseite, elektrische Module mit einer Oberseite und einer Unterseite und einen Kühlkörper aufweist, der thermisch mit der Unterseite der elektrischen Module gekoppelt ist. Dabei ist vorgesehen, dass der Kühlkörper eine strukturierte Oberseite aufweist, die eine Mehrzahl von Kavitäten und zwischen den Kavitäten angeordnete Auflagestrukturen umfasst, die eine Auflagefläche für die Leiterplatte bilden. Dabei liegt die Unterseite der Leiterplatte auf der Auflagefläche auf, wobei der aufliegende Bereich der Unterseite eine untere Anlagefläche bildet. Weiter ist vorgesehen, dass die elektrischen Module in die Kavitäten des Kühlkörpers hineinragen und dass an der Oberseite der Leiterplatte an Anpresspunkten, die der unteren Anlagefläche gegenüberliegen, vorstehende Strukturen eines Niederhalters oder eines Deckels anliegen, die die Anpresspunkte mit einer Niederhaltekraft beaufschlagen.

Die erfindungsgemäße Lösung beruht auf dem Gedanken, herkömmliche Schraubverbindungen zur Verbindung einer Leiterplatte mit einem Kühlkörper durch eine Anordnung zu ersetzen, bei der ein Anpressdruck der Leiterplatte an den Kühlkörper durch vorstehende Strukturen wie Pins oder Stege an der Unterseite eines Niederhalters oder eines Deckels breitgestellt wird, wobei die Leiterplatte zwischen solchen vorstehenden Strukturen und einer Auflagefläche des Kühlkörpers angeordnet ist und dabei spielfrei und ohne Unterbrechung des Kraftflusses die über die vorstehenden Strukturen an ihrer Oberseite eingeleitete Niederhaltekraft an ihrer Unterseite an den Kühlkörper weiter- und in diesen einleitet. Die Leiterplatte ist dabei gewissermaßen zwischen den vorstehenden Strukturen des Niederhalters oder des Deckels einerseits und der Auflagefläche an der Oberseite des Kühlkörpers eingeklemmt.

Die erfindungsgemäße Lösung ermöglicht die Reduzierung oder sogar eine vollständige Vermeidung von herkömmlichen Schraubverbindungen, so dass sich die Leistungsdichte der Leiterplatte durch eine Vergrößerung des Kupferquerschnitts der stromtragenden Innenlagen der Leiterplatte erhöht.

Ein weiterer, mit der Erfindung verbundener Vorteil besteht darin, dass eine kompaktere Bauweise durch die Vermeidung von bisher notwendigen Isolationsstrecken zwischen Metallschrauben und Kupferlagen ermöglicht wird.

Durch die erfindungsgemäße Lösung wird schließlich auch das Leiterplattenlayout vereinfacht, da keine Schraubverbindungen und die hierfür erforderlichen Metallgewinde in der Leiterplatte mehr benötigt werden oder zumindest eine reduzierte Anzahl an Schraubverbindungen vorliegt.

Dabei wird darauf hingewiesen, dass im Rahmen der vorliegenden Offenbarung der Begriff "Anpresspunkt" nicht als mathematischer Punkt zu verstehen ist, sondern als kleine Fläche bzw. als lokal begrenzter Bereich. Der Begriff "Anpresspunkt" zeigt auf, dass die eingeleitete Kraft in einem lokal begrenzten Bereich der Leiterplatte eingeleitet wird. Dieser lokale begrenzte Bereich kann zum Beispiel kreisförmig oder rechteckig oder auch in anderer Weise ausgebildet sein.

Es wird weiter darauf hingewiesen, dass im Sinne der vorliegenden Erfindung stets diejenige Seite der Leiterplatte, die dem Kühlkörper zugewandt ist, als Unterseite der Leiterplatte bezeichnet wird, unabhängig von der tatsächlichen Orientierung der Leiterplatte im Raum.

Eine Ausgestaltung der Erfindung sieht vor, dass die Leiterplattenanordnung einen Niederhalter umfasst, der an seiner Unterseite die vorstehenden Strukturen ausbildet, wobei der Niederhalter an der Oberseite der Leiterplatte angeordnet ist und die vorstehenden Strukturen des Niederhalters an den Anpresspunkten der Oberseite anliegen. Ein Niederhalter dient dabei allgemein dazu, die Leiterplatte in Richtung des Kühlkörpers zu drücken, so dass die an der Unterseite der Leiterplatte angeordneten elektrischen Module in einen intensiven thermischen Kontakt mit dem Kühlkörper treten können und dadurch eine verbesserte Kühlung erfahren. Der erfindungsgemäß verwendete Niederhalter bildet dabei derart vorstehende Strukturen an seiner Unterseite aus, dass die Leiterplatte zwischen der Auflagefläche an der Oberseite des Kühlkörpers und den vorstehenden Strukturen des Niederhalters angeordnet ist, so dass ein direkter Kraftfluss von den vorstehenden Strukturen über die Leiterplatte in den Kühlkörper erfolgen kann.

Dabei kann vorgesehen sein, dass der Niederhalter eine größere mechanische Steifigkeit aufweist als die Leiterplatte. Hierdurch wird sichergestellt, dass über den Niederhalter eine Anpresskraft der Leiterplatte und damit der an der Unterseite der Leiterplatte angeordneten elektrischen Module an den Kühlkörper erfolgt.

Der Niederhalter kann grundsätzlich eine beliebige Form und Ausgestaltung aufweisen, beispielsweise flächig oder durch Rippen gebildet sein. Zur Bereitstellung einer ausreichenden mechanische Steifigkeit ist in Ausführungsbeispielen vorgesehen, dass der Niederhalter Elemente aufweist oder aus Elementen besteht, die die Form eines T-Trägers oder eines Doppel-T-Trägers aufweisen. T-Trägers und Doppel-T-Träger weisen bekanntlich eine hohe Biegesteifigkeit auf. Bei den genannten Elementen handelt es sich beispielsweise um Rippen, die der Niederhalter ausbildet.

Eine weitere Ausgestaltung der Erfindung sieht vor, dass der Niederhalter in seinem Randbereich auf dem Kühlkörper aufliegt. Hierzu bildet der Kühlkörper Strukturen aus, die die Auflage des Niederhalters erlauben. Beispielsweise liegt der Niederhalter umlaufend auf dem Kühlkörper auf.

Dabei sieht ein Ausgangsbeispiel vor, dass der Niederhalter nur in seinem Randbereich mit dem Kühlkörper verschraubt ist, um eine sichere Befestigung des Niederhalters und damit der Leiterplatte am Kühlkörper sicherzustellen. Da Schraubverbindungen nur im Randbereich des Niederhalters realisiert sind, ist die zwischen dem Niederhalter und dem Kühlkörper angeordnete Leiterplatte von den Schraubverbindungen nicht oder ebenfalls nur in ihrem Randbereich tangiert.

Alternativ kann vorgesehen sein, dass die Leiterplattenanordnung zusätzlich einen Deckel aufweist, der den Niederhalter in seinem Randbereich gegen den Kühlkörper drückt. In diesem Fall wird der Kraftschluss zwischen Niederhalter und Kühlkörper über den Deckel bereitgestellt, ohne dass es Schraubverbindungen bedarf.

Dabei sieht eine Ausgestaltung vor, dass der Deckel zusätzlich vorstehende Strukturen wie z.B. Pins oder Stege ausbildet, die an Punkten an der Oberseite des Niederhalters anliegen, die den vorstehenden Strukturen an der Unterseite des Niederhalters gegenüberliegend angeordnet sind. Der Deckel ist somit dazu ausgebildet, auch seinerseits einen Druck von oben auf den Niederhalter auszuüben. Hierdurch kann die durch die vorstehenden Strukturen des Niederhalters bereitgestellte Niederhaltekraft gesichert oder sogar verstärkt werden. Auch wird eine Auswölbung des Niederhalters nach oben, die die Niederhaltekraft reduzieren würde, verhindert.

Eine Ausgestaltung sieht vor, dass der Niederhalter aus einem metallischen Material besteht. Beispielsweise handelt es sich um ein metallisches Metall mit einem hohen Elastizitätsmodul, wie beispielsweise Aluminium, Stahl, Federstahl und Titan. Sofern der Niederhalter aus einem elektrisch leitfähigen Material besteht, kann vorgesehen sein, dass der Niederhalter zur elektrischen Isolation mit einem elektrisch nichtleitenden Material zuminest teilweise beschichtet oder umspritzt ist. Bei Aluminium kann beispielsweise ein Eloxalverfahren zur elektrischen Isolierung eingesetzt werden.

Eine weitere Ausgestaltung der Erfindung sieht vor, dass die Leiterplattenanordnung ohne einen Niederhalter ausgebildet ist, jedoch einen Deckel umfasst, der die vorstehenden Strukturen ausbildet, wobei der Deckel an der Oberseite der Leiterplatte angeordnet ist und die vorstehenden Strukturen des Deckels an den Anpresspunkten der Oberseite anliegen. Bei dieser Ausgestaltung übernimmt der Deckel die bisher beschriebene Funktion des Niederhalters. Die vorstehenden Strukturen, die eine Niederhaltekraft erzeugen, sind dabei direkt am Deckel ausgebildet. Voraussetzung für diese Ausgestaltung ist eine Zugänglichkeit der Leiterplattenanordnung von oben. Beispielsweise ist bei dieser Ausgestaltung sicherzustellen, dass nicht oberhalb der betrachteten Leiterplatte weitere, darüber liegende Leiterplatten angeordnet sind (sogenannte Leiterplattenstacks). Sofern dies der Fall ist, wären die Leiterplattenstacks gegebenenfalls im Bereich des Deckels zu öffnen.

Es bestehen eine Vielzahl von Ausgestaltungen, wie der erforderliche Anpressdruck der Leiterplatte (und damit der an der Unterseite der Leiterplatte angeordneten elektrischen Module) an den Kühlkörper bereitgestellt werden kann.

Eine Ausgestaltung hierzu sieht vor, dass die vorstehenden Strukturen eines Niederhalters oder eines Deckels ein Übermaß in dem Sinne aufweisen, dass die vorstehenden Strukturen im montierten Zustand der Leiterplattenanordnung einen Anpressdruck auf die Oberseite der Leiterplatte ausüben. Die Länge der vorstehenden Strukturen ist somit derart bemessen, dass diese nicht lediglich ohne Spiel auf der Oberfläche der Leiterplatte aufliegen, sondern gewissermaßen etwas in die Oberfläche der Leiterplatte hinein drücken und hierdurch einen Anpressdruck bereitstellen.

Eine weitere Ausgestaltung hierzu sieht vor, dass die vorstehenden Strukturen eines Niederhalters oder eines Deckels federnd ausgebildet sind. Beispielsweise können hierfür Federn vorgesehen sein, die in Hülsen geführt werden, die in den vorstehenden Strukturen ausgebildet ist. Alternativ oder ergänzend kann vorgesehen sein, dass eine federnde Ausgestaltung auch im Bereich der Auflagefläche an der Oberseite des Kühlkörpers ausgebildet ist. Hierzu ist beispielsweise vorgesehen, dass im Bereich der Auflageflächen des Kühlkörpers federnde Elemente ausgebildet sind.

Eine weitere Ausgestaltung sieht vor, dass in den Kavitäten des Kühlkörpers zwischen der Unterseite der elektrischen Module und der Oberseite des Kühlkörpers ein Wärmeleitmaterial angeordnet ist. Hierdurch wird die thermische Kopplung der elektrischen Module mit dem Kühlkörper verbessert. Auch verhält es sich so, dass Wärmeleitmaterialien zum Ausgleich von Höhentoleranzen eingesetzt werden. Denn bei mehreren elektrischen Modul, die gekühlt werden müssen, verhält es sich so, dass Spalte mit unterschiedlichen Spaltmaßen zum Kühlkörper vorliegen können, die auszugleichen sind, um eine effektive Kühlung zu gewährleisten.

Als Wärmeleitmaterialien kommen beispielsweise Pastensysteme zum Einsatz, die auf die Kühlfläche appliziert werden und minimale Spalte und Rauheiten ausgleichen. Rechnet man mit höheren auszugleichenden Spaltmaßen, werden wärmeleitende Folien oder sogenannte Gappads oder Gap-Filler Materialen bis zu wenigen Millimetern Dicke eingesetzt. Solche Wärmeleitmaterialien werden auch als thermisches Schnittstellenmaterial (TIM) bezeichnet.

Eine weitere Ausgestaltung der Erfindung sieht vor, dass die Anpresspunkte der Oberseite der Leiterplatte, an denen vorstehende Strukturen anliegen, und/oder die Anlagefläche der Unterseite der Leiterplatte, die auf der Auflagefläche der strukturierten Oberseite des Kühlkörpers aufliegt, mechanisch verstärkt sind. Dabei erfolgt eine mechanische Verstärkung nicht über die gesamte Oberfläche der Leiterplatte, sondern nur im Bereich der Anpresspunkte, in denen die vorstehenden Strukturen in Anlage kommen.

Die Art der mechanischen Verstärkung kann vielfältig sein. Eine Ausgestaltung hierzu sieht vor, dass die mechanische Verstärkung durch mindestens ein oberes Metallpad und/oder mindestens ein unteres Metallpad gebildet ist. Dabei kann vorgesehen sein, dass eine mechanische Verstärkung durch mindestens zwei Metallpads gebildet ist, wobei die Metallpads zusätzlich durch metallische Vias verbunden sind. Durch das Anbringen von Vias bzw. Durchkontaktierungen, die ebenfalls metallisiert sind und die mindestens zwei Metallpads verbinden, wird die Anordnung mechanisch versteift. Bei den Metallpads handelt es sich beispielsweise um Kupferpads.

Eine weitere Ausgestaltung der Erfindung sieht vor, dass die Anpresspunkte an der Oberseite der Leiterplatte kreisförmig ausgebildet sind. Dementsprechend handelt sich bei den Strukturen des Niederhalters oder des Deckels, die gegen die Anpresspunkte drücken, um kreisförmige Pins. Dies ist jedoch nur beispielhaft zu verstehen. Beispielsweise kann alternativ vorgesehen sein, dass die Anpresspunkte rechteckförmig ausgebildet sind, wobei der Niederhalter oder Deckel Stege ausbildet, die gegen die Anpresspunkte drücken.

Eine weitere Ausgestaltung der Erfindung sieht vor, dass die Auflagestrukturen der strukturierten Oberseite des Kühlkörpers durch Stege gebildet sind, also längliche quaderförmige Strukturen. Die Stege begrenzen dabei die Kavitäten, die die an der Unterseite der Leiterplatte angeordneten elektrischen Module aufnehmen.

Die Erfindung wird nachfolgend unter Bezugnahme auf die Figuren der Zeichnung anhand mehrerer Ausführungsbeispiele näher erläutert. Es zeigen:

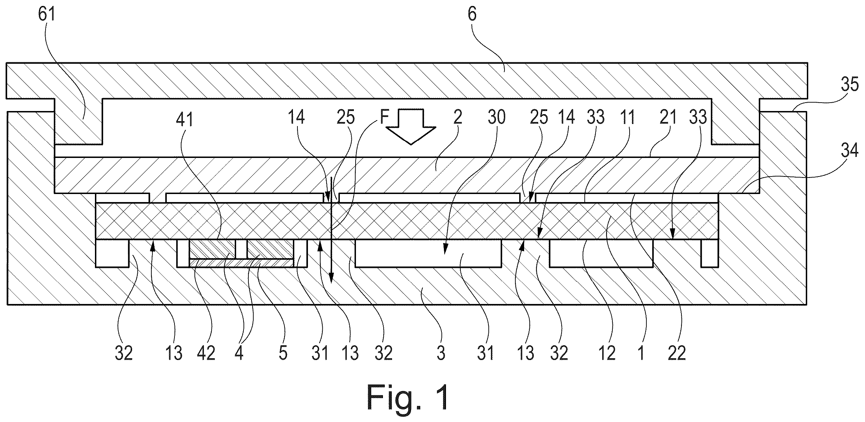

- Figur 1: ein Ausführungsbeispiel einer Leiterplattenanordnung mit einer Leiterplatte, die auf einem Kühlkörper aufliegt, wobei Pins oder Stege eines Niederhalters an Anpresspunkten an der Oberseite der Leiterplatte anliegen und die Anpresspunkte mit einer Niederhaltekraft beaufschlagen, und wobei die Anpresspunkte gegenüberliegend einer Anlagefläche an der Unterseite der Leiterplatte angeordnet sind, an der die Leiterplatte auf Auflagestrukturen des Kühlkörpers aufliegt;

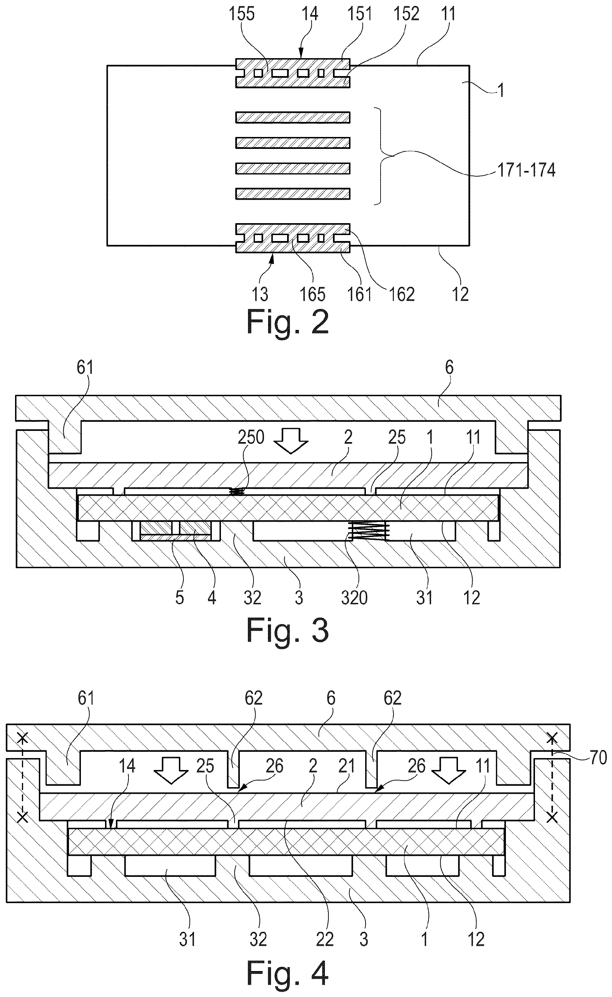

- Figur 2: Anpresspunkte und Anlageflächen einer Leiterplatte gemäß Figur 1, die durch Metallpads mechanisch verstärkt sind;
- Figur 3: eine Leiterplattenanordnung gemäß Figur 1, wobei Pins des Niederhalters und/oder Auflagestrukturen des Kühlkörpers federnd ausgebildet sind;
- Figur 4: eine Leiterplattenanordnung gemäß Figur 1, wobei die Leiterplattenanordnung einen Deckel umfasst, der ebenfalls Pins oder Stege ausbildet, die an Punkten an der Oberseite des Niederhalters anliegen, die den Pins oder Stegen an der Unterseite des Niederhalters gegenüberliegend angeordnet sind;

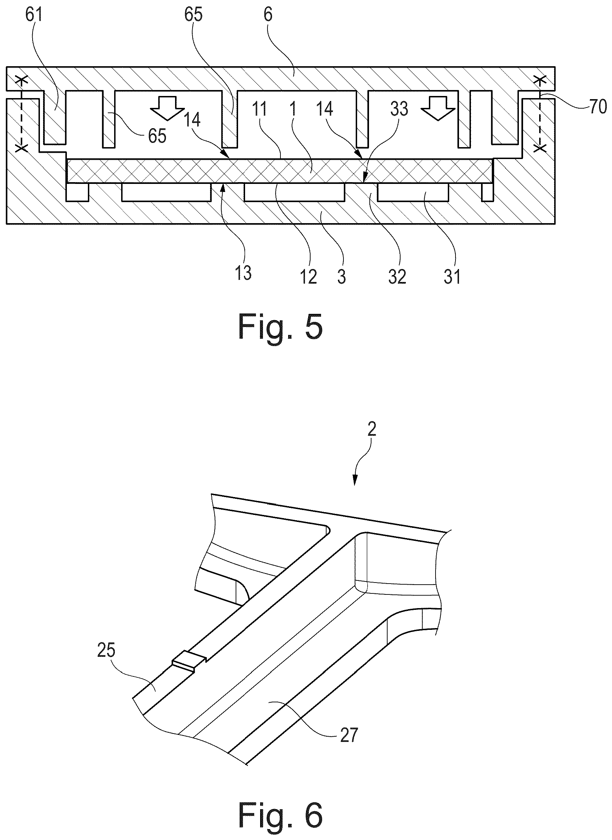

- Figur 5: ein weiteres Ausführungsbeispiel einer Leiterplattenanordnung mit einer Leiterplatte, die auf einem Kühlkörper aufliegt, wobei Pins oder Stege eines Deckels an Anpresspunkten an der Oberseite der Leiterplatte anliegen und die Anpresspunkte mit einer Niederhaltekraft beaufschlagen, und wobei die Anpresspunkte gegenüberliegend einer Anlagefläche an der Unterseite der Leiterplatte angeordnet sind, an der die Leiterplatte auf Auflagestrukturen des Kühlkörpers aufliegt;
- Figur 6: eine beispielhafte Darstellung eines Niederhalters; und

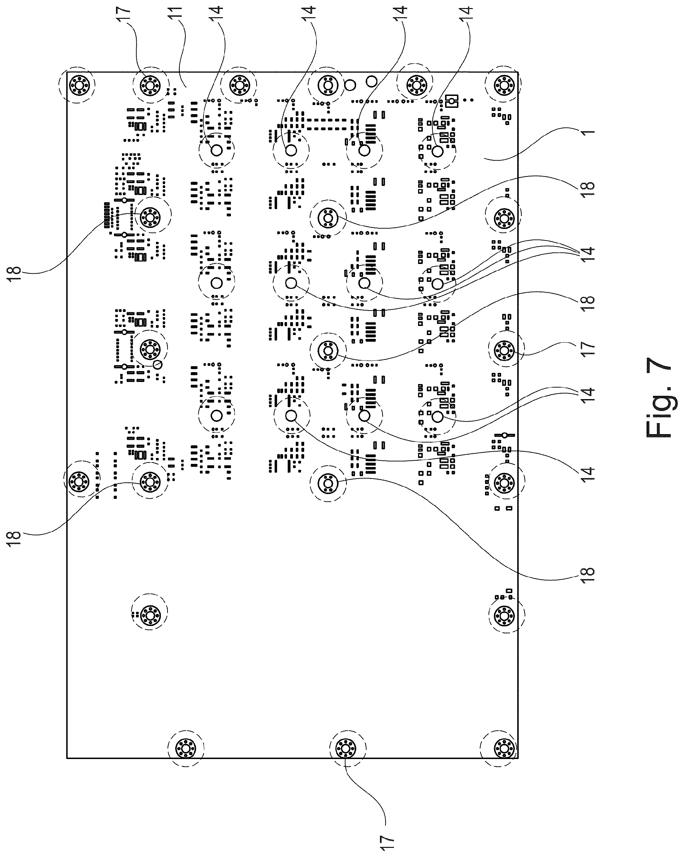

- Figur 7: eine Draufsicht auf die Oberseite einer Leiterplatte, wobei Anpresspunkte dargestellt sind, an denen Pins eines Niederhalters oder eines Deckels gemäß den Leiterplattenanordnungen der Figuren 1 und 3 bis 5 zur Anlage kommen und eine Niederhaltekraft einleiten, und wobei zusätzlich Schraubverbindungen gemäß dem Stand der Technik dargestellt sind.

Die Figur 1 zeigt eine Leiterplattenanordnung, die eine Leiterplatte 1, elektrischen Module 4, einen Kühlkörper 3, einen Niederhalter 2 und einen Deckel 6 umfasst.

Die Leiterplatte 1 kann aus einer Vielzahl von Leiterplattenlagen (nicht gesondert dargestellt) bestehen, die übereinander angeordnet sind. Dabei bildet eine oberste Leiterplattenlage eine Oberseite 11 der Leiterplatte 1 und eine unterste Leiterplattenlage eine Unterseite 12 der Leiterplatte 1.

Auf der Unterseite 12 der Leiterplatte 1 sind die elektrischen Module 4 angeordnet, die jeweils eine Oberseite 41 und eine Unterseite 42 aufweist. Die Verbindung der elektrischen Module 4 mit der Leiterplatte 1 erfolgt über eine Oberflächenmontage, wobei elektrische Kontaktflächen (Lotpads) an der Unterseite 12 der Leiterplatte 1 über Lotverbindungen mit elektrischen Kontaktflächen auf der Oberseite 41 der elektrischen Module 4 elektrisch verbunden sind. Bei den elektrischen Modulen 4 handelt es sich um aktive Bauteile, beispielsweise Bauteile oder Baugruppen der Leistungselektronik, die einer Kühlung durch den Kühlkörper 3 bedürfen.

Der Kühlkörper 3 weist eine strukturierte, der Leiterplatte 1 zugewandte Oberseite 30 auf. Die Strukturierung der Oberseite 30 ist derart, dass an der Oberseite 30 eine Mehrzahl von Kavitäten bzw. Aussparungen 31 ausgebildet ist. Zwischen den Kavitäten 31 befinden sich dabei Auflagestrukturen in Form von vorstehenden Stegen 32. Die Oberseite der Stege 32 bildet dabei eine Auflagefläche 33 für die Leiterplatte 1. Die Bereiche der Unterseite der Leiterplatte, die auf der Auflagefläche 33 aufliegen, bilden eine untere Anlagefläche 13 der Leiterplatte.

Die elektrischen Module 31 ragen in die Kavitäten 31 hinein. Dabei deckt die Leiterplatte 1 die Kavitäten 31 an der Oberseite ab. Zwischen den zu kühlenden Modulen 4 und dem Kühlkörper 3 ist in der Kavität 31 auf einer Bodenfläche des Kühlkörpers 3 ein optionales Wärmeleitmaterial 5 angeordnet, das die Unterseite 42 der elektrischen Module 4 thermisch mit dem Kühlkörper 3 koppelt und auch als thermisches Schnittstellenmaterial (TIM) bezeichnet wird. Hierbei handelt es sich beispielsweise um eine Wärmeleitmatte oder eine Wärmeleitpaste. Durch das Wärmeleitmaterial 5 wird ein Spalt zwischen dem jeweiligen Modul 4 und dem Kühlkörper 3 vermieden.

Es wird darauf hingewiesen, dass in der Figur 1 nur zwei der elektrischen Module 4 dargestellt sind. Tatsächlich befinden sich in jeder Kavität 31 in entsprechender Weise elektrischen Module. Dabei kann vorgesehen sein, dass die elektrischen Module jeweils in Reihen hintereinander angeordnet sind (senkrecht zur Bildebene der Figur 1).

Die durch die Stege 32 voneinander getrennten Kavitäten 31 können allgemein in einer Vielzahl von geometrischen Anordnungen ausgebildet sein. Beispielsweise kann vorgesehen sein, dass die Kavitäten 31 mehrere parallele Reihen bilden, die durch die Stege 32 voneinander getrennt sind. In anderen Ausführungsbeispielen kann vorgesehen sein, dass die Kavitäten rechteckig oder quadratisch ausgebildet sind und an allen vier Seiten von Stegen 32 umgeben sind.

Oberhalb der Leiterplatte 1 ist der Niederhalter 2 angeordnet. Der Niederhalter 2 weist eine Oberseite 21 und eine der Leiterplatte 1 zugewandte Unterseite 22 auf. An der Unterseite 22 des Niederhalters 2 sind dabei eine Mehrzahl von vorstehenden Strukturen in Form von Pins oder Stegen 25 angeordnet. Unter "Pins" werden dabei in Richtung der Leiterplatte 1 vorstehende Strukturen bezeichnet, die zumindest näherungsweise punktförmig, beispielsweise kreisförmig ausgebildet sind. Unter "Stegen" werden in Richtung der Leiterplatte 1 vorstehende Strukturen bezeichnet, die eine längliche Erstreckung aufweisen. Bei den Stegen handelt sich beispielsweise um längliche, quaderförmigen Strukturen. Grundsätzlich können die vorstehenden Strukturen auch eine andere Form, beispielsweise eine Wellenform aufweisen. In der folgenden Beschreibung wird zwischen Pins und Stegen nicht unterschieden, da beide in der betrachteten Querschnittsansicht die Struktur 25 bilden können.

Es verhält sich so, dass die Pins oder Stege 25 des Niederhalters an der Oberseite 11 der Leiterplatte an Anpresspunkten 14 anliegen. Die Pins oder Stege 25 sind dabei derart ausgebildet, dass sie einen Druck auf die Anpresspunkte 14 auf der Oberseite 11 der Leiterplatte 1 ausüben, wobei die Stirnseiten der Pins oder Stege 25 an den Anpresspunkten 14 zur Anlage kommen. Über die Anpresspunkte 14 leiten die Pins oder Stege 25 eine Niederhaltekraft in die Leiterplatte 1 ein. Die Anpresspunkte 14 liegen dabei den unteren Anlagenflächen 13 gegenüber. Hierdurch wird ermöglicht, dass ein Kraftfluss (beispielhaft dargestellt durch den Pfeil F) vom Niederhalter 2, nämlich den Pins oder Stegen 25 des Niederhalters 2, über die Leiterplatte 1 in die Auflagestrukturen 32 des Kühlkörpers 3 und den Kühlkörper 3 erfolgt. Die auf diese Weise an mehreren Anpresspunkten 14 auf der Oberseite 11 der Leiterplatte 1 bereitgestellte Niederhaltekraft sichert, dass die Leiterplatte 1 und damit die an der Unterseite 12 der Leiterplatte 1 angeordneten elektrischen Module 4 in einen thermischen Kontakt mit dem Kühlkörper 3 treten und entsprechend effizient gekühlt werden. Dies wird durch die spezielle Struktur mit den vorstehende Strukturen 25, den Anpresspunkten 14 an der Oberseite 11 der Leiterplatte 1, den gegenüberliegenden Anlageflächen 13 an der Unterseite 12 der Leiterplatte 1 und den Auflagestrukturen 32 des Kühlkörpers 3 erreicht, ohne dass hierzu eine Schraubverbindung erforderlich ist.

Der Niederhalter 2 liegt in seinem Randbereich auf einer Auflagefläche 34 des Kühlkörpers 3 auf. Zur Sicherung der vertikalen Position des Niederhalters 2 ist ein Deckel 6 vorgesehen, der auf einer Fläche 35 des Kühlkörpers 3 aufliegt. Der Deckel 6 umfasst vorstehende Stege 61 oder einen vorstehenden umlaufenden Rand 61, die/der bei Befestigung des Deckels 6 auf dem Kühlkörper 3 den Rand des Niederhalters 2 gegen den Kühlkörper 3 drücken/drückt und dabei in seiner vertikalen Position sichern/sichert.

Optional kann zusätzlich vorgesehen sein, dass der Niederhalter 2 in seinem Randbereich (im Bereich der Auflagefläche 34) mit dem Kühlkörper verschraubt ist. Weiter kann vorgesehen sein, dass der Deckel im Bereich der Auflagefläche 35 mit dem Kühlkörper verschraubt ist. Solche Verschraubungen betreffen aber nicht die Leiterplatte 1.

Der Niederhalter 2 kann eine größere mechanische Steifigkeit aufweisen als die Leiterplatte 1, so dass eine effiziente Krafteinleitung über die vorstehenden Strukturen 25 in die Leiterplatte 1 möglich ist. Dabei kann vorgesehen sein, dass der Niederhalter aus einem metallischen Material besteht wie beispielsweise Aluminium, Stahl, Federstahl oder Titan. Weiter kann vorgesehen sein, dass der Niederhalter 2 für eine elektrische Isolation mit einem nichtleitenden Material beschichtet oder umspritzt ist.

Weiter kann vorgesehen sein, dass die Pins oder Stege 25 ein leichtes Übermaß aufweisen, somit im montierten Zustand nicht lediglich an der Oberseite 11 der Leiterplatte 1 anliegen, sondern aufgrund ihres Übermaßes eine Kraft in die Anpresspunkte 14 einleiten.

Für eine effektive Kraftleitung der in die Anpresspunkte 14 eingeleiteten Niederhaltekraft ist es vorteilhaft, wenn die Anpresspunkte 14 auf der Oberseite 11 der Leiterplatte 1 und die Anlageflächen 13 an der Unterseite 12 der Leiterplatte 1, die auf der Auflagefläche 33 der Stege 32 des Kühlkörpers aufliegen, mechanisch verstärkt sind. Ein Ausführungsbeispiel hierfür ist in der Figur 2 dargestellt.

Die Figur 2 zeigt eine Leiterplatte 1 mit einer Oberseite 11 und einer Unterseite 12. An der Oberseite 11 ist entsprechend der Figur 1 ein Anpresspunkt 14 dargestellt. An der Unterseite 12 ist entsprechend der Figur 1 eine Anlagefläche 13 dargestellt. Der obere Anpresspunkt 14 ist dabei durch zwei Kupferpads 151, 152 gebildet, die mittels Durchkontaktierungen 155 verbunden sind, um die Versteifung zu erhöhen und die mechanische Stabilität zu verstärken. In entsprechender Weise ist die untere Anlagefläche durch zwei Kupferpads 161, 162 gebildet, die mittels Durchkontaktierungen 165 miteinander verbunden sind. In der Figur 2 sind des Weiteren eine Mehrzahl von stromführenden Kupferschichten 171-174 dargestellt, zwischen den sich isolierte Schichten befinden, wie dem Fachmann bekannt ist. Die jeweils durch Durchkontaktierungen miteinander verbundenen Kupferpads 151, 152, 161, 162 bilden jeweils eine die mechanische Stabilität verstärkende Schichtstruktur.

Es wird darauf hingewiesen, dass die Kupferpads 151, 152, 161, 162 mit den Durchkontaktierungen 155, 165 nicht der Stromführung dienen. Die entsprechenden Schichten sind keine stromführenden Schichten und nicht elektrisch mit den anderen Schichten 171-174 der Schaltung verbunden. Die Kupferpads 151, 152, 161, 162 können die Form kreisförmiger oder rechteckiger Pads von begrenzter Größe haben.

Die Figur 3 zeigt eine Abwandlung des Ausführungsbeispiels der Figur 1, die sich vom Ausführungsbeispiel der Figur 1 dadurch unterscheidet, dass die vorstehenden Strukturen an der Unterseite des Niederhalters 2 und/oder die Auflagestrukturen 32 der Kavität 3 jeweils federnd ausgebildet sind. So ist beispielhaft und schematisch dargestellt, dass die vorstehenden Strukturen 25 an der Unterseite des Niederhalters 2 federnde Elemente 250 aufweisen. Beispielsweise umfassen Pins 25 Federn 250, die in einer Hülse geführt werden. Ebenfalls ist beispielhaft und schematisch dargestellt, dass die Auflagestruktur 32 an der Oberseite des Kühlkörpers 3 federnde Elemente 320 aufweist. Beispielsweise umfassen die Stege 32 Federn 320, die in einer Hülse geführt werden. Die federnde Ausbildung dient dazu, einen Anpressdruck bereitzustellen.

Die Figur 4 zeigt eine weitere Abwandlung des Ausführungsbeispiels der Figur 1, die sich vom Ausführungsbeispiel der Figur 1 dadurch unterscheidet, dass auch der Deckel 6 an seiner Innenseite vorstehende Strukturen in Form von Pins oder Stegen 62 aufweist. Die Pins oder Stege 62 des Deckels 6 sind dabei derart positioniert, dass sie an Punkten 26 an der Oberseite 21 des Niederhalters 2 anliegen, die den Pins oder Stegen 25 an der Unterseite 22 des Niederhalters 2 gegenüberliegen. Die Pins oder Stege 62 verhindern, dass der Niederhalter 2 sich nach oben wölben kann, für welchen Fall die auf die Anpresspunkte 14 wirkende Niederhaltekraft reduziert würde. Durch die Positionierung der Pins oder Stege 62 des Deckels 6 und der Pins oder Stege 25 des Niederhalters 2 an gegenüberliegenden Seiten des Niederhalters 2 wird dabei eine effektive Krafteinleitung in die Anpresspunkte 14 sichergestellt.

Dabei kann vorgesehen sein, dass der Deckel 6 in seinem Randbereich über schematisch dargestellt Schraubverbindungen 70 mit dem Kühlkörper 3 verschraubt ist, so dass der Niederhalter 2 in vertikaler Richtung gesichert ist.

Die Figur 5 zeigt eine weitere Abwandlung des Ausführungsbeispiels der Figur 1, wobei im Ausführungsbeispiel der Figur 5 kein Niederhalter vorhanden ist. Die Funktion des Niederhalters wird dabei durch den Deckel 6 übernommen. Dabei bildet der Deckel 6 an seiner Unterseite vorstehende Strukturen in Form von Pins oder Stegen 65 aus, die an der Oberseite des Niederhalters 2 anliegen und die Anpresspunkte 14 des Niederhalters 2 mit einer Niederhaltekraft beaufschlagen.

Dabei kann vorgesehen sein, dass der Deckel 6 in seinem Randbereich über schematisch dargestellt Schraubverbindungen 70 mit dem Kühlkörper 3 verschraubt ist, so dass eine kontinuierliche Krafteinleitung über die Anpresspunkte 14 in die Leiterplatte 1 sichergestellt ist.

Es wird darauf hingewiesen, dass die elektrischen Module 4 in den Figuren 4 und 5 nicht gesondert dargestellt, jedoch in gleicher Weise wie in Bezug auf die Figur 1 beschrieben an der Unterseite der Leiterplatte 1 angeordnet sind und in die Kavitäten 31 hineinragen.

Die Figur 6 zeigt beispielhaft ein Ausführungsbeispiel eines Niederhalters 2, der lediglich in Abschnitten dargestellt ist. Der Niederhalter umfasst dabei rippenförmige Elemente 27 in Form eines T-Trägers, um eine hohe Steifigkeit zu erreichen. Dabei stehen Stege 25 vor, die den Stegen 25 der Figuren 1, 3 und 4 entsprechen. Die Figur 6 verdeutlicht, dass der Niederhalter 2 grundsätzlich in einer Vielzahl von Ausgestaltungen bereitgestellt werden kann. Er kann entsprechend der Figur 6 aus einzelnen Rippen bestehen, die beispielsweise die Form eines T-Trägers oder eines Doppel-T-Trägers aufweisen. Er kann aber auch flächig ausgebildet sein, beispielsweise als Platte, an der die vorstehenden Strukturen 25 abstehen.

Die Figur 7 zeigt eine Draufsicht auf die Oberseite 11 einer Leiterplatte 1. Die Darstellung dient der Verdeutlichung der mit der vorliegenden Erfindung verbundenen Vorteile. So umfasst die Darstellung herkömmliche Metallgewinde 17, 18, die Metallschrauben aufnehmen und zur Bereitstellung von Schraubverbindungen dienen. Die Metallgewinde 17 befinden sich dabei am Rand der Leiterplatte 1 und die Metallgewinde 18 befinden sich im Inneren der Leiterplatte. Die Metallgewinde 17,18 bewirken eine Unterbrechung und Reduzierung des Kupferquerschnitts der einzelnen Kupferlagen der Leiterplatte.

Die Figur 7 zeigt des Weiteren Anpresspunkte 14, an denen in einer erfindungsgemäßen Leiterplattenanordnung gemäß den Figuren 1-5 Stege oder Pins oder andere vorstehende Strukturen eines Niederhalters oder eines Deckels zur Anlage kommen. Die Anpresspunkte 14 sind dabei kreisförmig ausgebildet und werden dementsprechend mittels Pins eines Niederhalters oder eines Deckels mit einer Kraft beaufschlagt.

Die Anpresspunkte 14 ersetzen dabei die Metallgewinde 17, 18, wobei der Kupferquerschnitt der stromtragenden Innenlagen der Leiterplatte 1 vergrößert wird. Alternativ werden lediglich die innenliegenden Metallgewinde 18 durch die Anpresspunkte 14 ersetzt, wobei die außenliegenden Metallgewinde 17 für eine zusätzliche Sicherung der Leiterplatte 1 durch seitliche Schraubverbindungen verbleiben. Dies beeinflusst den Stromverlauf innerhalb der Leiterplatte 1 nicht signifikant, vergrößert lediglich etwas die notwendige Fläche der Leiterplatte 1.

Es versteht sich, dass die Erfindung nicht auf die oben beschriebenen Ausführungsformen beschränkt ist und verschiedene Modifikationen und Verbesserungen vorgenommen werden können, ohne von den hier beschriebenen Konzepten abzuweichen. Weiter wird darauf hingewiesen, dass beliebige der beschriebenen Merkmale separat oder in Kombination mit beliebigen anderen Merkmalen eingesetzt werden können, sofern sie sich nicht gegenseitig ausschließen. Die Offenbarung dehnt sich auf alle Kombinationen und Unterkombinationen eines oder mehrerer Merkmale aus, die hier beschrieben werden und umfasst diese. Sofern Bereiche definiert sind, so umfassen diese sämtliche Werte innerhalb dieser Bereiche sowie sämtliche Teilbereiche, die in einen Bereich fallen.

## Patentansprüche

1. Leiterplattenanordnung, die aufweist:
- eine Leiterplatte (1) mit einer Oberseite (11) und einer Unterseite (12),
- elektrische Module (4) mit einer Oberseite (41) und einer Unterseite (42), die mit ihrer Oberseite (41) an der Unterseite (12) der Leiterplatte (1) angeordnet sind,
- einen Kühlkörper (3), der thermisch mit der Unterseite (42) der elektrischen Module (4) gekoppelt ist,
**dadurch gekennzeichnet, dass**
der Kühlkörper (3) eine strukturierte Oberseite (30) aufweist, die eine Mehrzahl von Kavitäten (31) und zwischen den Kavitäten (31) angeordnete Auflagestrukturen (32) umfasst, die eine Auflagefläche (33) für die Leiterplatte (1) bilden, wobei
- die Unterseite (12) der Leiterplatte (1) auf der Auflagefläche (33) aufliegt, wobei der aufliegende Bereich der Unterseite (12) eine untere Anlagefläche (13) bildet,
- die elektrischen Module (4) in die Kavitäten (31) des Kühlkörpers (3) hineinragen, und
- an der Oberseite (11) der Leiterplatte (1) an Anpresspunkten (14), die der unteren Anlagefläche (13) gegenüberliegen, vorstehende Strukturen (25, 65) eines Niederhalters (2) oder eines Deckels (6) anliegen, die die Anpresspunkte (14) mit einer Niederhaltekraft beaufschlagen.

2. Leiterplattenanordnung nach Anspruch 1, **dadurch gekennzeichnet, dass** die Leiterplattenanordnung einen Niederhalter (2) umfasst, der an seiner Unterseite (22) die vorstehenden Strukturen (25) ausbildet, wobei der Niederhalter (2) an der Oberseite (11) der Leiterplatte (1) angeordnet ist und die vorstehenden Strukturen (25) des Niederhalters (2) an den Anpresspunkten (14) der Oberseite (11) anliegen.

3. Leiterplattenanordnung nach Anspruch 1 oder 2, **dadurch gekennzeichnet, dass** der Niederhalter (2) eine größere mechanische Steifigkeit aufweist als die Leiterplatte (1).

4. Leiterplattenanordnung nach Anspruch 3, **dadurch gekennzeichnet, dass** der Niederhalter (2) Elemente (27) aufweist oder aus Elementen besteht, die die Form eines T-Trägers oder eines Doppel-T-Trägers aufweisen.

5. Leiterplattenanordnung nach einem der vorangehenden Ansprüche, **dadurch gekennzeichnet, dass** der Niederhalter (2) in seinem Randbereich auf dem Kühlkörper (3) aufliegt, und/oder der Niederhalter (2) nur in seinem Randbereich mit dem Kühlkörper (3) verschraubt ist.

6. Leiterplattenanordnung nach einem der Ansprüche 1 bis 5, **dadurch gekennzeichnet, dass** die Leiterplattenanordnung zusätzlich einen Deckel (6) aufweist, der den Niederhalter (2) in seinem Randbereich gegen den Kühlkörper (3) drückt, wobei insbesondere der Deckel (6) zusätzlich vorstehenden Strukturen (62) ausbildet, die an Punkten (26) an der Oberseite (21) des Niederhalters (2) anliegen, die vorstehenden Strukturen (25) an der Unterseite (22) des Niederhalters (2) gegenüberliegend angeordnet sind.

7. Leiterplattenanordnung nach einem der vorangehenden Ansprüche, **dadurch gekennzeichnet, dass** der Niederhalter (2) aus einem metallischen Material besteht.

8. Leiterplattenanordnung nach Anspruch 1, **dadurch gekennzeichnet, dass** die Leiterplattenanordnung ohne einen Niederhalter ausgebildet ist, jedoch einen Deckel (6) umfasst, der vorstehende Strukturen (65) ausbildet, wobei der Deckel (6) an der Oberseite der Leiterplatte (1) angeordnet ist und die vorstehenden Strukturen (65) des Deckels (6) an den Anpresspunkten (14) der Oberseite (11) anliegen.

9. Leiterplattenanordnung nach einem der vorangehenden Ansprüche, **dadurch gekennzeichnet, dass** die vorstehenden Strukturen (25, 65) ein Übermaß in dem Sinne aufweisen, dass die vorstehenden Strukturen (25, 65) im montierten Zustand der Leiterplattenanordnung einen Anpressdruck auf die Oberseite (11) der Leiterplatte (1) ausüben.

10. Leiterplattenanordnung nach einem der vorangehenden Ansprüche, **dadurch gekennzeichnet, dass** die vorstehenden Strukturen (25, 65) federnd ausgebildet sind, und/oder im Bereich der Auflageflächen (33) des Kühlkörpers (3) federnde Elemente (320) ausgebildet sind.

11. Leiterplattenanordnung nach einem der vorangehenden Ansprüche, **dadurch gekennzeichnet, dass** in den Kavitäten (31) des Kühlkörpers (3) zwischen der Unterseite (42) der elektrischen Module (4) und der Oberseite des Kühlkörpers (3) ein Wärmeleitmaterial (5) angeordnet ist.

12. Leiterplattenanordnung nach einem der vorangehenden Ansprüche, **dadurch gekennzeichnet, dass** die Anpresspunkte (14) der Oberseite (11) der Leiterplatte (1), an denen vorstehende Strukturen (25, 65) anliegen, und/oder die Anlagefläche (13) der Unterseite (12) der Leiterplatte (1), die auf der Auflagefläche (33) der strukturierten Oberseite (30) des Kühlkörpers (3) aufliegt, mechanisch verstärkt sind.

13. Leiterplattenanordnung nach Anspruch 12, **dadurch gekennzeichnet, dass** die mechanische Verstärkung durch mindestens ein oberes Metallpad (151, 152) und/oder mindestens ein unteres Metallpad (161, 162) gebildet ist, wobei insbesondere eine mechanische Verstärkung durch mindestens zwei Metallpads (151, 152; 161, 162) gebildet ist, wobei die Metallpads (151, 152; 161, 162) durch metallische Vias (155, 165) verbunden sind.

14. Leiterplattenanordnung nach einem der vorangehenden Ansprüche, **dadurch gekennzeichnet, dass** die vorstehenden Strukturen (25, 65) durch Pins oder Stege gebildet sind, und/oder die Anpresspunkte (14) an der Oberseite (11) der Leiterplatte (1) kreisförmig ausgebildet sind.

15. Leiterplattenanordnung nach einem der vorangehenden Ansprüche, **dadurch gekennzeichnet, dass** die Auflagestrukturen der strukturierten Oberseite (30) des Kühlkörpers (3) durch Stege (32) gebildet sind.
